# FASCICULE DE BREVET EUROPEEN

(11) **EP 3 551 574 B1**
(45) Date de publication et mention de la délivrance du brevet: **01.12.2021**
(21) Numéro de dépôt: 17825411.6
(22) Date de dépôt: 08.12.2017
(51) Int. Cl.: H01L 21/762, B81B 3/00

(54) **RÉDUCTION DE CAPACITÉS PARASITES DANS UN DISPOSITIF MICROÉLECTRONIQUE**
VERRINGERUNG PARASITÄRER KAPAZITÄTEN IN EINEM MIKROELEKTRONISCHEN BAUELEMENT
DECREASE OF PARASITIC CAPACITANCES IN A MICROELECTRONIC DEVICE

(30) Priorité: 12.12.2016 FR 1662276
(43) Date de publication de la demande: 16.10.2019
(73) Titulaire: Commissariat à l'Énergie Atomique et aux Énergies Alternatives, 75015 Paris (FR)
(72) Inventeur: ROBERT, Philippe, 38000 Grenoble (FR); LOUWERS, Stephanus, 38500 La Buisse (FR)
(74) Mandataire: Decobert, Jean-Pascal
(86) Numéro de dépôt international: PCT/EP2017/082093
(87) Numéro de publication internationale: WO 2018/108753

(56) Documents cités:
- US-A- 6 104 054
- US-A1- 2011 147 859

## Description

### DOMAINE DE L'INVENTION

La présente invention concerne en général les dispositifs microélectroniques. Elle s'adresse en particulier à des dispositifs présentant des portions, telles des pistes en des matériaux électriquement conducteurs, susceptibles de conduire des signaux électriques.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS , NOEMS ...). Il peut s'agir de transducteurs ayant par exemple une fonction de transformation du son en signal électrique, pour une application à des microphones notamment.

### ARRIERE-PLAN TECHNOLOGIQUE

La microélectronique se déploie dans de nombreuses applications avec une miniaturisation et une finesse de fonctionnement croissantes. Dans le cas de capteurs par exemple, des couches sensibles très fines sont utilisables et les signaux de mesure sont de faibles valeurs de courant. Dans ces conditions, il arrive que des paramètres électriques environnant le ou les composants actifs du dispositif deviennent non négligeables dans le traitement électrique des signaux de mesure. Une difficulté est en particulier posée par les capacités parasites : des parties électriquement conductrices et des zones diélectriques forment, avec le substrat semi-conducteur (généralement du silicium), des empilements capacitifs risquant de perturber les mesures. Ces capacités parasites peuvent se retrouver aussi dans la dimension large du dispositif, perpendiculairement à l'épaisseur du substrat semi-conducteur.

On a déjà cherché à résoudre le problème des capacités parasites. Par exemple, la publication US A1 6 104 054 montre une méthode de réduction des capacités parasites dans un circuit intégré formé sur un support basé sur un substrat de type Silicium sur Isolant, généralement connu sous l'acronyme SOI (de l'anglais « Silicon On Insulator »). Des tranchées isolantes en dioxyde de silicium forment, en association avec la couche isolante du SOI, des caissons d'isolation électrique d'une partie centrale du caisson, dans laquelle est située une partie active à transistor. Ces tranchées assurent la fonction de couches diélectriques d'entrefer de sorte à créer des capacités en série avec les capacités parasites. Cette combinaison de capacités en série réduit la valeur globale. En effet, la capacité résultante Cr est égale à : Cr = 1/ (1/C1+1/C2) où C1 est la capacité parasite et C2 est une capacité additionnelle créée par une tranchée. On comprend que Cr est nécessairement inférieure à C1 (et à C2), réduisant ainsi les effets parasites.

Si cette disposition de tranchées est satisfaisante dans son effet de réduction des capacités parasites, elle reste difficile à mettre en oeuvre dans un procédé global de fabrication, en particulier parce que les tranchées fragilisent le substrat et le rendent sensible aux agressions chimiques.

C'est donc un objet de l'invention que de pallier au moins en partie les inconvénients des techniques actuelles, en offrant un dispositif microélectronique amélioré réduisant les capacités parasites.

### RESUME DE L'INVENTION

Un aspect non limitatif de l'invention est relatif à un dispositif microélectronique comprenant :
- un substrat comportant en empilement une portion de base, une portion diélectrique et une couche supérieure à base de matériau semi-conducteur,
- au moins un élément de raccordement électrique en un matériau électriquement conducteur situé au-dessus de la couche supérieure et isolé électriquement de la couche supérieure au moins par une couche diélectrique, la couche diélectrique étant au contact de la surface de la couche supérieure,
- au moins un élément diélectrique comprenant au moins une tranchée remplie d'un matériau diélectrique solide, ladite tranchée formant un contour fermé en périphérie ou au droit d'au moins une partie de l'élément de raccordement électrique, située au moins en partie dans la couche supérieure et délimitant une zone fermée de ladite couche supérieure, l'au moins un élément diélectrique ayant une partie exposée à la surface de la couche supérieure,
dispositif dans lequel la couche diélectrique recouvre totalement la partie exposée de l'au moins un élément diélectrique.

Ainsi, la couche diélectrique et le ou les éléments diélectriques forment un ensemble intégral et cohérent permettant d'isoler efficacement l'élément de raccordement électrique ; ils créent des capacités additionnelles servant à réduire les capacités parasites produites inévitablement par l'élément de raccordement électrique au-dessus de la couche semi-conductrice. En effet, ces capacités additionnelles se placent en série des capacités parasites et tendent donc à réduire la capacité globale qui en découle.

On notera que cet ensemble comprenant la couche diélectrique et le ou les éléments diélectriques s'étend à la fois dans la dimension du substrat et suivant son épaisseur de sorte que les capacités parasites sont atténuées dans ces deux directions. D'un point de vue fabrication, on peut aisément réaliser les éléments diélectriques en oxyde, typiquement de l'oxyde de silicium, sans risquer de les endommager lors d'autres phases de fabrication ; en effet, ils sont protégés par la couche diélectrique qui est avantageusement résistante à la gravure de l'oxyde. Par exemple, le procédé peut comprendre des phases de libération de parties mécaniques (notamment des parties mobiles de capteurs) par gravure de zones d'oxyde, mais ces phases n'impacteront pas négativement l'intégrité des éléments diélectriques.

Un autre aspect séparable de la présente invention concerne un procédé de fabrication d'un dispositif microélectronique comprenant un substrat comportant en empilement une portion de base, une portion diélectrique et une couche supérieure à base de matériau semi-conducteur.

Avantageusement, il est caractérisé en ce qu'il comprend :
- la formation d'au moins un élément diélectrique situé au moins en partie dans la couche supérieure, l'au moins un élément diélectrique ayant une partie exposée à la surface de la couche supérieure, ledit au moins un élément diélectrique comprenant au moins une tranchée remplie d'un matériau diélectrique solide et délimitant une zone fermée de ladite couche supérieure, en périphérie ou au droit d'au moins une partie d'un élément de raccordement électrique;
- la formation d'une couche diélectrique au contact de la surface de la couche supérieure et qui recouvre totalement la partie exposée de l'au moins un élément diélectrique ;
- la formation dudit élément de raccordement électrique en un matériau électriquement conducteur au-dessus de la couche supérieure et isolé électriquement de la couche supérieure au moins par la couche diélectrique.

De préférence, le procédé comprend la formation d'au moins une zone en un matériau sacrificiel dans la couche supérieure, puis la gravure du matériau sacrificiel alors que le au moins un élément diélectrique est recouvert par la couche diélectrique.

De préférence, le procédé comprend la formation d'au moins une zone en un matériau sacrificiel opérée avant la formation de la couche diélectrique, simultanément à la formation de l'au moins un élément diélectrique.

De préférence, le procédé comprend la formation de la couche diélectrique comprenant un dépôt pleine plaque puis une gravure configurée pour préserver le matériau de la couche diélectrique au-dessus de l'au moins un élément diélectrique sans préserver le matériau de la couche diélectrique (40) au-dessus de la zone en un matériau sacrificielle.

### BREVE INTRODUCTION DES FIGURES

D'autres caractéristiques, buts et avantages de la présente invention apparaîtront à la lecture de la description détaillée qui suit, en regard des dessins annexés, donnés à titre d'exemples, non limitatifs, et sur lesquels :
- les figures 1 et 2 illustrent respectivement en vue de dessus et en coupe un exemple de substrat de base de l'invention, suivant la technologie SOI ;
- les figures 3 et 4 montrent respectivement en vue de dessus et en coupe une étape de formation de tranchées dans la couche supérieure du substrat ;
- les figures 5 et 6 montrent respectivement en vue de dessus et en coupe une étape de formation de parties d'oxyde dans les tranchées, donnant ainsi un exemple de réalisation d'éléments diélectriques et de zones de matériau sacrificiel ;
- la figure 7 montre une étape de formation d'une électrode inférieure ; les figures 8a et 8b en donnent des vues de détail;
- la figure 9 schématise un recouvrement par une couche diélectrique, par exemple piézoélectrique ;
- la figure 10 montre la réalisation d'ouvertures dans la couche diélectrique et la figure 11 en donne un détail dans la continuité de la figure 8, avec la réalisation de vias ;
- la figure 12 est relative à une étape de formation d'éléments de raccordement électrique ;
- la figure 13 illustre un enlèvement partiel de la couche diélectrique de sorte à exposer certaines zones de la surface su substrat tout en laissant couvertes d'autres parties ;

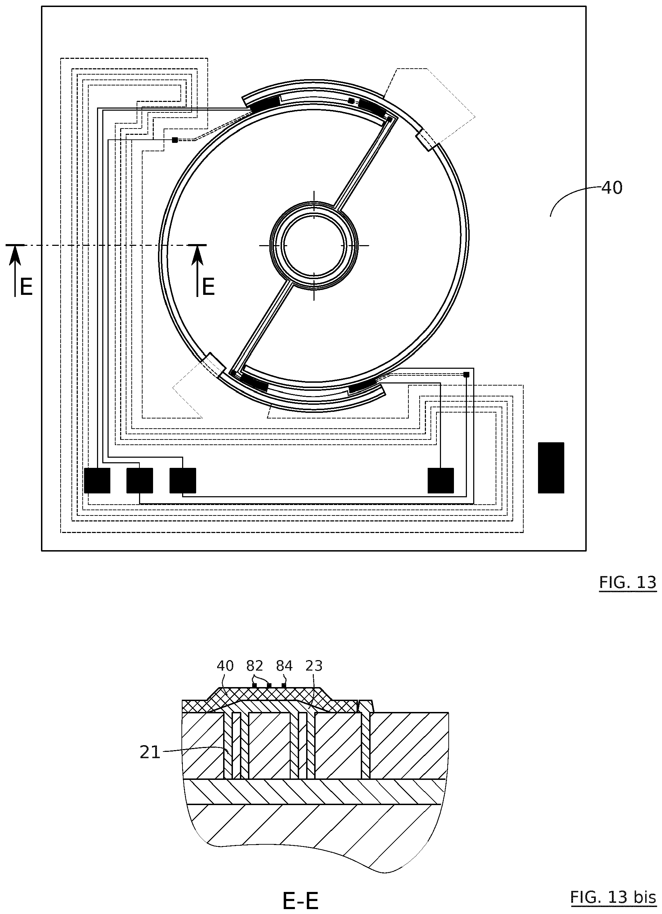

- la figure 13bis est une coupe de la figure 13 ;

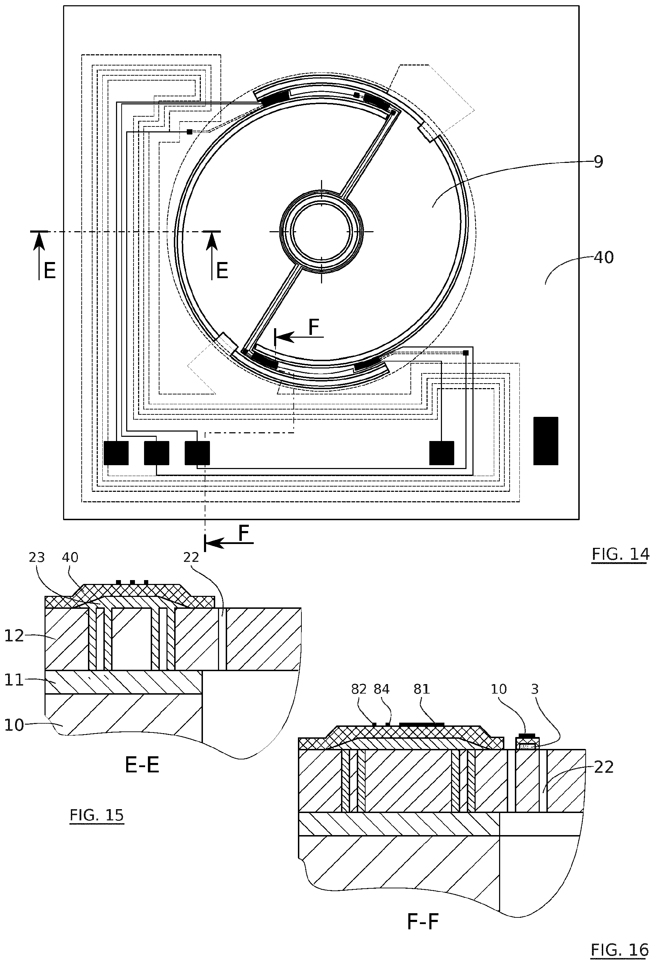

- la figure 14 présente une étape de libération de parties suivant l'épaisseur du substrat ; les figures 15 et 16 en donnent aussi une illustration suivant deux coupes différentes ;

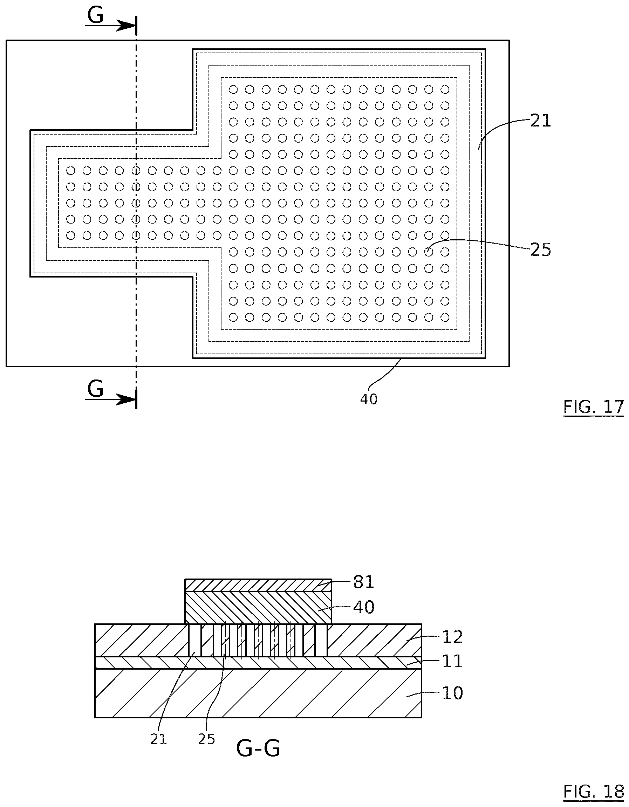

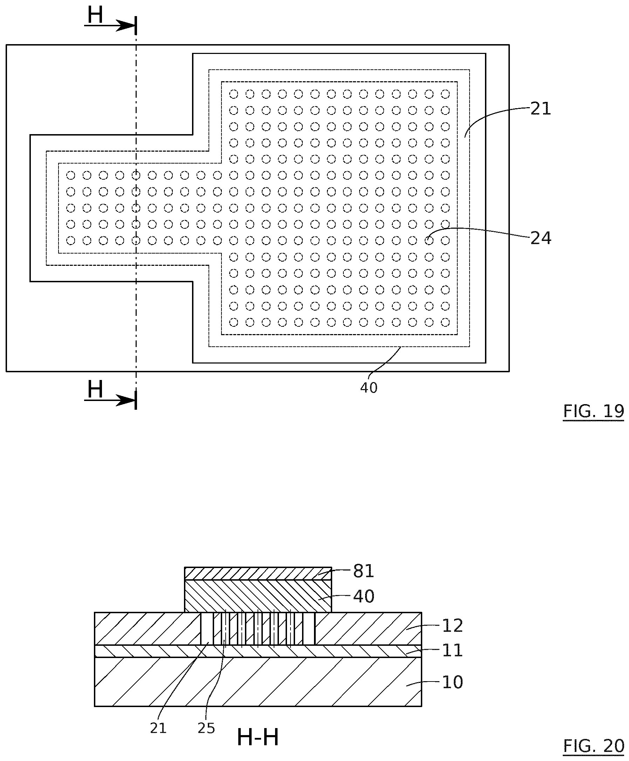

- les figures 17 et 18 donnent un premier exemple de formation d'éléments diélectriques et les figures 19 et 20 en fournissent une alternative.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- le au moins un élément diélectrique 2 et la couche diélectrique 40 sont en des matériaux différents ;
- l'au moins un élément diélectrique 2 est en dioxyde de silicium et la couche diélectrique 40 est résistante à une gravure à l'acide fluorhydrique ;
- au moins un élément de raccordement électrique est en continuité électrique avec une première électrode 100 d'un empilement capacitif.
- l'empilement capacitif comprend une deuxième électrode 3 située en-dessous d'une partie de la couche diélectrique 40, au moins une partie de la première électrode étant située en regard de la deuxième électrode et isolée de celle-ci par ladite partie de la couche diélectrique 40;
- une sous-couche diélectrique 31 est située entre la couche supérieure 12 et la deuxième électrode 3.

Ce mode de réalisation est intéressant notamment dans le cas des applications piézoélectriques dans lesquelles la couche 40 est une couche piézoélectrique. La couche 31 (généralement en AIN) permet d'obtenir une orientation de grains de la couche 40 optimisant ses propriétés piézoélectriques.
- un élément de raccordement électrique additionnel en un matériau électriquement conducteur est situé au-dessus de la couche supérieure 12 et isolé électriquement de la couche supérieure 12 au moins par une zone de la couche diélectrique 40, l'élément de raccordement électrique additionnel étant en continuité électrique avec la deuxième électrode 3 par un via 6 traversant la couche diélectrique 40 ;
- la couche diélectrique 40 est de nature piézoélectrique ;
- l'au moins un élément diélectrique 2 comprend au moins un pilier 24 dont la dimension longue s'étend au moins suivant un partie au moins de l'épaisseur de la couche supérieure 12.
- au moins un pilier 24 est situé en regard de l'élément de raccordement sous la couche diélectrique 40 ;
- au moins un élément diélectrique 2 comprend un réseau de tranchées défini en creux dans l'épaisseur de la couche supérieure 12 autour d'une pluralité de piliers 25 s'étendant dans l'épaisseur de la couche supérieure 2 ;
- au moins un pilier 25 est situé en regard de l'élément de raccordement sous la couche diélectrique ;
- l'au moins un élément diélectrique 2 comprend une tranchée 21 formant un contour fermé en périphérie ou au droit d'au moins une partie de l'élément de raccordement électrique ;
- l'au moins un élément diélectrique 2 comprend une pluralité de tranchées 21, 22 ;
- au moins une tranchée 21 entoure au moins un pilier 24 ;
- au moins une tranchée 21 entoure au moins un pilier 25 ;
- l'au moins un élément diélectrique 2 comprend une première partie située dans la couche supérieure 12 et une deuxième partie 23 située au-dessus de la couche supérieure ;
- l'élément de raccordement électrique comprend un plot de connexion ;
- la couche diélectrique 40 est plus large que l'élément de raccordement électrique et au moins un élément diélectrique 2 est situé en regard d'une partie de la couche diélectrique 40 non recouverte par l'élément de raccordement ;
- l'élément diélectrique 2 parcourt toute l'épaisseur de la couche supérieure 12 et rejoint la portion diélectrique 11.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou d'un substrat se mesure selon une direction perpendiculaire à la surface selon laquelle cette couche ou ce substrat présente son extension maximale.

Un support, par exemple à base d'un substrat, notamment semi-conducteur peut être commun à plusieurs dispositifs de l'invention au moins durant la fabrication. Une pluralité de dispositifs sera généralement réalisée sur ce support. Une découpe s'ensuivra pour individualiser les dispositifs.

Certaines parties du dispositif de l'invention ont une fonction électrique. Certaines sont employées pour des propriétés de conduction électrique et on entend par électrode ou équivalent, des éléments formés d'au moins un matériau ayant une conductivité suffisante, dans l'application, pour réaliser la fonction souhaitée. C'est le cas, de manière générale, des parties appelées éléments de raccordement électriques ; ce peut être des pads, des électrodes, des lignes de redistribution électrique.... D'autres parties, au contraire, sont employées pour des propriétés d'isolation électrique et tout matériau ayant une résistivité suffisante pour réaliser cette isolation sont concernées et sont notamment appelées diélectriques.

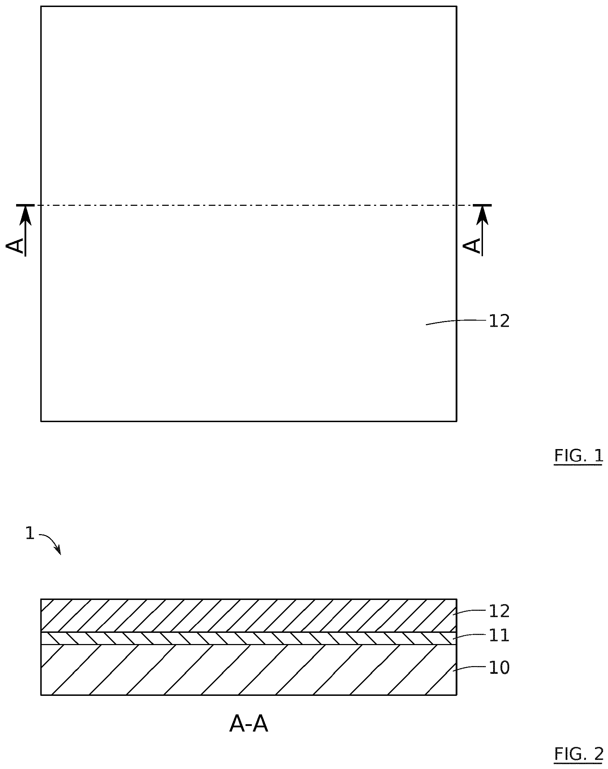

La présente invention peut être mise en oeuvre à partir d'un substrat de type conventionnel et notamment à partir d'un substrat utilisant la technologie Silicium sur isolant, en anglais « Silicon On Insulator » ou SOI. La représentation des figures 1 et 2 correspond à ce dernier exemple. En figure 2, un substrat 1 comprend une portion de base 10 par exemple en silicium brut, une portion diélectrique 11 située au-dessus de la portion 10 et par exemple réalisée à partir d'un matériau semi-conducteur isolant, typiquement du dioxyde de silicium. Au-dessus de la portion diélectrique 11, une couche supérieure 12 est présente, à base de matériaux semi-conducteurs, typiquement du silicium monocristallin. La figure 1 n'illustre que la face supérieure de cet empilement qui est à ce stade uniquement constituée de ce matériau semi-conducteur.

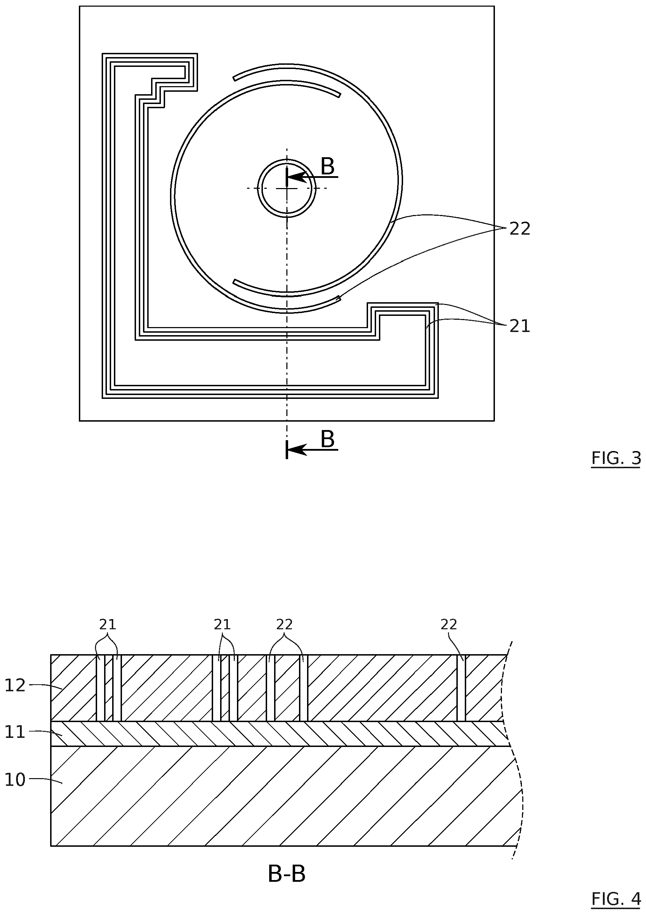

Une étape de réalisation de l'invention consiste à former des tranchées dans la couche. Ainsi, la figure 3 illustre des tranchées 21 réalisées sur une zone prédéterminée de la couche supérieure 12. Avantageusement, comme le montre la figure 4, la profondeur des tranchées 21 correspond à l'épaisseur de la couche supérieure 12 de sorte que les tranchées parviennent jusqu'à la portion diélectrique 11. On verra que ces tranchées 21 servent à réaliser des tranchées isolantes remplies d'un matériau diélectrique. Parallèlement, on peut réaliser d'autres tranchées 22 pour d'autres parties du process de fabrication du dispositif micro-électronique visé. En l'espèce, des tranchées 22 sont également réalisées pour venir, ultérieurement, libérer certaines portions de la couche supérieure 12, ces portions pouvant notamment être destinées à informer les parties mobiles d'un dispositif microélectronique mécanique. La technique de réalisation des tranchées n'est pas limitative de l'invention et notamment tout type de gravure pourra être mis en oeuvre, par exemple par voie sèche ou par voie humide. La ou les tranchées 22 ne sont de préférence pas recouvertes par la couche diélectrique 40 et ne participent pas aux éléments diélectriques. La ou les tranchées 22, ainsi formées dans au moins la couche 12, définissent de préférence le contour d'une partie qui sera mobile après gravure d'une partie sous-jacente de la couche 11.

La forme et le nombre des tranchées 22 dépendent du type de dispositif microélectronique à fabriquer. En ce qui concerne les tranchées 21, on peut former une ou plusieurs tranchées ; ces tranchées peuvent en outre présenter, comme dans l'exemple de la figure 3, un contour fermé de sorte à ceinturer une portion de la couche supérieure 12 spécifique. Dans le cas des figures 3 et 4, deux tranchées de profil homothétique sont réalisées sur une portion de la couche supérieure 12 s'étendant au niveau de deux côtés dudit substrat. D'une façon générale, il est avantageux de former les tranchées 22 dans une portion de la couche supérieure 12 au niveau de laquelle une densité d'éléments de connexion électrique (plots de reprise de contact, les lignes de redistribution etc.) est importante.

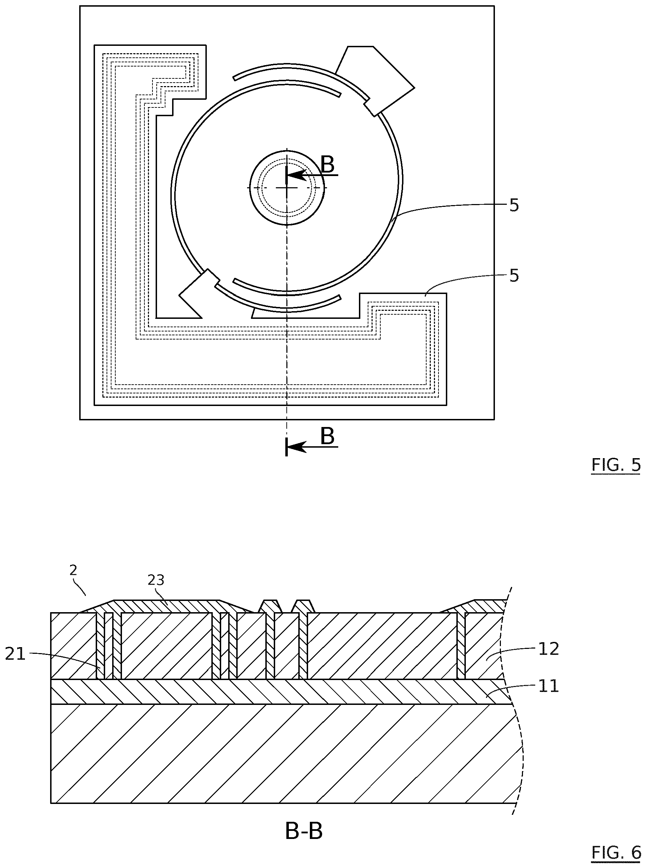

La figure 5 illustre la formation d'un remplissage en un matériau électriquement isolant des tranchées précédemment réalisées. De préférence, le matériau employé est un oxyde, notamment de l'oxyde de silicium déposé depuis la face de la couche supérieure 12, possiblement par toutes techniques conventionnelles et par exemple par oxydation thermique après masquage des zones de la couche supérieure 12 dont le recouvrement ou le remplissage par l'oxyde n'est pas souhaité. La figure 5 illustre les zones au niveau desquelles le matériau diélectrique est déposé. Typiquement, il peut s'agir du volume intérieur des tranchées 22 et des tranchées 21. Avantageusement, une portion surfacique de la couche supérieure 12 est également recouverte de l'oxyde. La figure 6 en donne une illustration avec un remplissage des tranchées 21 et d'une partie de la surface de la couche supérieure 12. Le remplissage des tranchées 21 et de la portion de surface forme avantageusement un ensemble cohérent et continu, ces deux portions étant réalisées d'un seul tenant lors de l'opération d'oxydation. On forme ainsi suivant un premier mode de réalisation des éléments diélectriques situés dans ce cas en partie à l'intérieur de la couche supérieure 12 et en partie à la surface de celle-ci. En se référant à la figure 5, la partie surfacique de la couche d'oxyde recouvre intégralement le contour défini par les tranchées 21 et, la figure 6 illustre la portion surfacique de l'oxyde qui dépasse latéralement le contour fermé ainsi défini. La tranche de la portion surfacique du matériau diélectrique (du dioxyde de silicium dans cet exemple) peut être droite ou présenter un plan incliné, par exemple de 15° à 20° par rapport au plan de la surface supérieure de la couche supérieure 12.

D'une manière générale, la définition des tranchées 21 et le remplissage assurent que le ou les éléments diélectriques issus de la formation de ce matériau diélectrique sont exposés à la surface de la couche supérieure 12. Ainsi, on isole sur au moins une partie de l'épaisseur de la couche supérieure 12 certaines zones de celle-ci jusqu'à sa surface.

Dans le même temps, le remplissage des tranchées 22 est destiné à préserver dans celles-ci un matériau sacrificiel ensuite enlevé pour la libération de parties du dispositif.

L'intérêt de l'invention est de pouvoir mettre en oeuvre des parties électriquement conductrices dans le dispositif microélectronique tout en bénéficiant d'une isolation contre les capacités parasites.

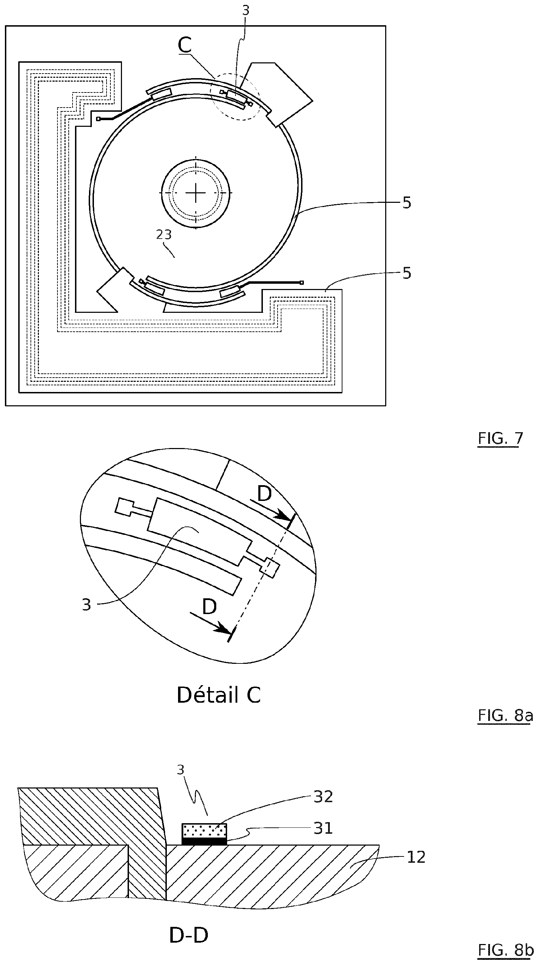

La formation de certaines parties conductrices est illustrée aux figures 7 et 8a, 8b avec la fabrication d'une deuxième électrode 3 par exemple en molybdène. La ou les électrodes 3 (quatre dans l'exemple) peuvent être déposées sur des parties au niveau desquelles l'oxyde a été déposé ou encore, comme dans l'exemple de la figure 8, sur une sous-couche 31 de nature diélectrique déposée préliminairement au dépôt du matériau de la partie conductrice 32 de la deuxième électrode 3. Le matériau diélectrique de la couche 31 peut être du nitrure d'aluminium. Suivant une autre possibilité, le matériau de l'électrode 3 est en continuité électrique avec celui de la couche supérieure 12 semi-conductrice. Ou encore une portion au moins de la couche 12 forme l'électrode 3. Ainsi, plutôt que de prévoir une électrode 3 isolée électriquement de la couche supérieure 12, il est possible de constituer au moins en partie cette dernière par le matériau de la couche supérieure 12.

La ou les deuxièmes électrodes 3 sont dans cet exemple situées dans des zones au niveau desquelles des contraintes mécaniques seront constatées. En effet, l'exemple donné est relatif à un dispositif électromécanique présentant une partie mobile dont la définition finale sera donnée ultérieurement, cette partie mobile étant ancrée relativement au reste du dispositif formant son support et des moyens de détection de mouvement étant placés dans au moins une de ces zones d'ancrage. Plus précisément, dans l'exemple ici considéré, les moyens de détection comprennent une pluralité de capteurs de nature piézoélectrique comprenant en empilement une deuxième électrode, une couche aux propriétés piézoélectriques et une première électrode. On comprend que les mouvements de la partie mobile du capteur sont mesurés dans les zones dotées des empilements capacitifs piézoélectriques en question de sorte à mesurer l'amplitude du mouvement de la partie mobile.

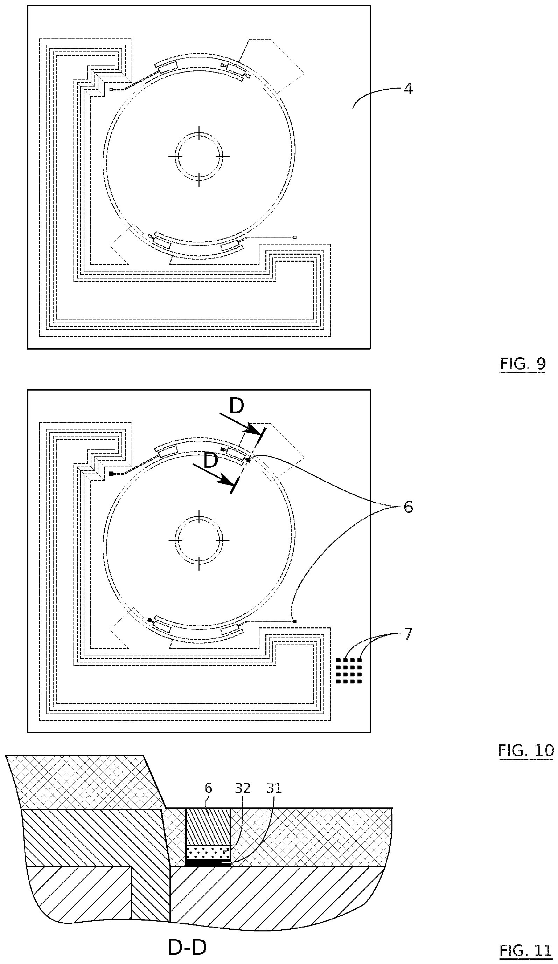

Ainsi, les deuxièmes électrodes 3 peuvent former un premier niveau de conduction, typiquement métallique, dans l'ensemble du dispositif de l'invention. Pour isoler ce premier niveau relativement à la suite de l'empilement, l'invention propose le dépôt d'une couche d'un matériau diélectrique, avantageusement réalisé pleine plaque et représenté sous la référence 4 à la figure 9. On peut utiliser du nitrure d'aluminium ou un autre matériau ayant des propriétés diélectriques et avantageusement des propriétés piézoélectriques. Ainsi, en une seule étape, on réalise une isolation électrique du premier niveau métallique et la formation d'une couche piézoélectrique dans l'intention de former la couche intermédiaire des empilements capacitifs des capteurs du dispositif électromécanique.

Avant ce dépôt, suivant une première option, on a réalisé des lignes de conduction électrique depuis les deuxièmes électrodes 3 jusqu'à des éléments de reprise de contact, tels des plots de connexion électrique du dispositif. Ces lignes de redistribution électrique et les plots eux-mêmes ou des pads peuvent être réalisés dans la continuité des électrodes 3 et courir à la surface supérieure de la couche supérieure 12. Une autre option, correspondant à l'exemple représenté à la figure 10 est de constituer des passages électriques au travers de l'épaisseur de la couche 4 de sorte à opérer une redistribution électrique du premier niveau métallique correspondant aux deuxièmes électrodes 3 par le dessus de la couche de matériau diélectrique 4. Ainsi, la figure 11 montre en détail un via passant au travers de la couche 4 et raccordant une deuxième électrode 3 à la surface de la couche 4. De même, la figure 10 illustre une pluralité de passages traversant la couche 4 et formant des ouvertures 7 susceptibles de raccorder le dispositif à la terre.

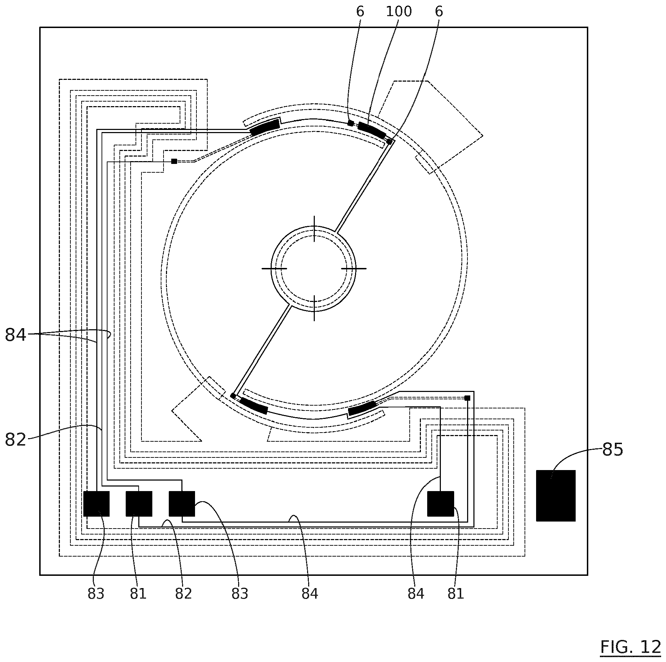

L'étape suivante est illustrée à la figure 12 avec la formation d'un deuxième niveau de conduction électrique par-dessus la couche 4. En particulier, on forme des premières électrodes 10 en correspondance des deuxièmes électrodes 3 précédemment réalisées de sorte à finaliser les empilements de deux électrodes et du matériau piézoélectrique intercalé. Le deuxième niveau conducteur comprend en outre des lignes de connexion 82 du niveau supérieur permettant de raccorder les premières électrodes 10 à des éléments de reprise de contact 81. Dans cet exemple, on opère en outre le raccordement électrique des deuxièmes électrodes sous-jacentes 3 par le dessus de la couche 4. La figure 12 en donne une illustration avec des lignes de connexion 84 et des reprises de contact 83 permettant le raccordement du niveau inférieur électrique au travers des via 6. Une reprise de contact 85 est prévue pour le raccordement à la terre, dans la continuité électrique des ouvertures 7 qui sont elles-mêmes remplies d'un matériau de conduction électrique.

Durant toutes ces étapes, la couche 4 est employée comme couche électriquement isolante pour faire courir les éléments électriques entre les électrodes et les reprises de contact. On peut ensuite réaliser la libération mécanique d'une partie mobile 9 du capteur. L'exemple donné en figure 13 montre un enlèvement partiel du matériau de la couche 4 de sorte à laisser réapparaître la surface supérieure de la couche supérieure 12 à certains endroits et de sorte à exposer les tranchées 22. Parallèlement, les autres parties du dispositif et en particulier les zones comportant les éléments diélectriques formés au moins en partie par les tranchées 21 sont laissées recouvertes du matériau résiduelle 40 de la couche 4, elles sont donc protégées durant cette étape. La figure 13bis en est l'illustration. On notera que les tranchées 22 ont des portions d'extrémité imbriquées définissant des bras de suspension de la partie mobile 9, ces bras formant des zones d'ancrage de la partie relativement au support. C'est dans ce niveau que sont situés les empilements de détection comprenant une première électrode 10, une deuxième électrode 3 et une couche piézoélectrique. La ou les zones correspondant à ces ancrages, ou bras de suspension, restent également recouvertes du matériau de la couche 4 et les tranchées 22 encadrant cette zone sont exposées.

Un résultat de cette étape est fourni aux figures 14 à 16 appelé libération de la partie mobile. Plus précisément, la figure 15 montre une tranchée 22 dans laquelle le matériau de remplissage a été supprimé. Typiquement, lorsqu'il s'agit d'oxyde de silicium, la suppression peut s'opérer par une gravure humide à l'acide fluorhydrique. La figure 16 montre d'autres parties libérées d'autres tranchées 22. Dans le même temps, ces figures illustrent que les éléments diélectriques 2 sont protégés par la couche diélectrique 40 ayant été préservée à l'issue de l'enlèvement partiel de la couche diélectrique pleine plaque 4.

La couche 40 recouvre intégralement le ou les éléments diélectriques 2 si bien que l'attaque à l'acide fluorhydrique n'impacte pas cette portion.

Ces figures en coupe permettent en outre de visualiser l'empilement capacitif formé entre les éléments métalliques formant les reprises de contact 81 et les lignes de connexion 82 et les couches sous-jacentes, notamment la couche supérieure de matériau semi-conducteur 12. Ainsi, en figure 16, la reprise de contact 81 se superpose à la couche supérieure 12 avec la couche 40 et l'élément diélectrique 2 situé de manière intermédiaire en réalisant des capacités en série permettant de diminuer la capacité parasite produite par cette partie du dispositif.

On notera que dans l'exemple des modes de réalisation illustrés aux figures 15 et 17, la couche de protection 40 recouvre l'élément diélectrique 2 simultanément à d'autres parties du dispositif pour réaliser les empilements de détection qui comporte une deuxième électrode 3, une première électrode 10 et le matériau piézoélectrique intercalaire. Ainsi, même si cette caractéristique n'est pas limitative de l'invention, il est avantageux d'utiliser comme couche diélectrique 40 un matériau de nature piézoélectrique pouvant être déposé lors d'une étape servant à la fois à constituer la couche piézoélectrique, des capteurs et la couche diélectrique 40 de protection des éléments diélectriques 2.

Ces figures présentent un mode de réalisation de l'élément diélectrique 2 comportant en outre une portion intégrée dans l'épaisseur de la couche supérieure 12, une portion à la surface de cette dernière. Cette portion surfacique forme une deuxième partie d'élément diélectrique 2 référencée 23 à la figure 15 pour illustration, les tranchées 21 formant une première partie

Les figures 17 à 20 montrent d'autres exemples de réalisation de l'invention avec des éléments diélectriques 2 affleurant la surface de la couche supérieure 12 sans en dépasser.

Un premier cas correspondant aux figures 17 et 18 montre la définition d'une tranchée 21 autour d'une partie électrique, dans l'exemple un élément de reprise de contact 81, et autour d'une ligne de connexion 82 partant de cette reprise de contact 81 Ainsi, les parties électriques sont entourées d'au moins une tranchée 21 formant une première partie d'isolation électrique limitant les capacités parasites. Outre cette partie, on forme un quadrillage d'oxydes en dessous de la couche 40 par un réseau en lignes et en colonnes de tranchées parcourant l'épaisseur de la couche supérieure 12, préférentiellement jusqu'à la portion diélectrique 11. Ce quadrillage définit des piliers 25 en matériau semi-conducteur de la couche 12. Le réseau diélectrique ainsi constitué forme une pluralité de capacités parasites alliant des capacités diélectriques additionnelles en série avec les capacités parasites et réduisant fortement ces dernières. Suivant un mode de réalisation, le réseau diélectrique issu de ce quadrillage est situé intégralement dans un espace défini au droit des éléments électriquement conducteurs, ici les éléments 81, 82.

Les figures 19 et 20 montrent une autre possibilité de structure d'un tel réseau, réalisé cette fois négativement relativement au cas précédent, à savoir que les piliers réalisés dans l'épaisseur de la couche supérieure 12 sont cette fois des piliers dans le matériau diélectrique, typiquement le dioxyde de silicium. Une ou plusieurs tranchées 21 peuvent être définies comme précédemment.

Avantageusement, cette ou ces tranchées sont au droit de la bordure de l'élément de raccordement électrique superposé à la couche diélectrique ou en périphérie de la projection de cette bordure suivant l'épaisseur du substrat, mais toujours en dessous de la couche diélectrique 40.

### REFERENCES

- 1.: Substrat
- 10.: Portion de base
- 11.: Portion diélectrique
- 12.: Couche supérieure
- 2.: Elément diélectrique
- 21.: Tranchée de première partie
- 22.: Tranchée de définition de partie mobile
- 23.: Deuxième partie
- 24.: Pilier
- 25.: Pilier semi-conducteur
- 3.: Deuxième électrode
- 31.: Sous-couche diélectrique
- 32.: Partie conductrice
- 4.: Dépôt diélectrique pleine plaque
- 40.: Couche diélectrique
- 5.: Oxyde
- 6.: Via
- 7.: Ouverture
- 81.: Reprise de contact de niveau supérieur
- 82.: Ligne de connexion de niveau supérieur
- 83.: Reprise de contact de niveau inférieur
- 84.: Ligne de connexion de niveau inférieur
- 85.: Reprise de contact terre
- 9.: Partie mobile
- 100.: Première électrode

## Revendications

1. Dispositif microélectronique comprenant :
- un substrat (1) comportant en empilement une portion de base (10), une portion diélectrique (11) et une couche supérieure (12) à base de matériau semi-conducteur,
- au moins un élément de raccordement électrique (81, 82, 84)en un matériau électriquement conducteur situé au-dessus de la couche supérieure (12) et isolé électriquement de la couche supérieure au moins par une couche diélectrique (40), la couche diélectrique (40) étant au contact de la surface de la couche supérieure (12),
- au moins un élément diélectrique (2) comprenant au moins une tranchée (21) remplie d'un matériau diélectrique solide, ladite tranchée (21) formant un contour fermé en périphérie ou au droit d'au moins une partie de l'élément de raccordement électrique (81, 82, 84), située au moins en partie dans la couche supérieure (12) et délimitant une zone fermée de ladite couche supérieure, l'au moins un élément diélectrique (2) ayant une partie exposée à la surface de la couche supérieure,
dispositif dans lequel la couche diélectrique (40) recouvre totalement la partie exposée de l'au moins un élément diélectrique (2).

2. Dispositif selon la revendication précédente, dans lequel le au moins un élément diélectrique (2) et la couche diélectrique (40) sont en des matériaux différents.

3. Dispositif selon la revendication précédente, dans lequel l'au moins un élément diélectrique (2) est en dioxyde de silicium et dans lequel la couche diélectrique (40) est résistante à une gravure à l'acide fluorhydrique, et de préférence dans lequel la couche diélectrique (40) est de nature piézoélectrique.

4. Dispositif selon l'une des revendications précédentes, dans lequel l'au moins un élément de raccordement électrique (81, 82, 84) est en continuité électrique avec une première électrode (100) d'un empilement capacitif.

5. Dispositif selon la revendication précédente, dans lequel l'empilement capacitif comprend une deuxième électrode (3) située en-dessous d'une partie de la couche diélectrique (40), au moins une partie de la première électrode (100) étant située en regard de la deuxième électrode et isolée de celle-ci par ladite partie de la couche diélectrique (40), et de préférence dans lequel une sous-couche diélectrique (31) est située entre la couche supérieure (12) et la deuxième électrode (3), et le dispositif comprenant de préférence un élément de raccordement électrique additionnel en un matériau électriquement conducteur situé au-dessus de la couche supérieure (12) et isolé électriquement de la couche supérieure (12) au moins par une zone de la couche diélectrique (40), l'élément de raccordement électrique additionnel étant en continuité électrique avec la deuxième électrode (3) par un via (6) traversant la couche diélectrique (40).

6. Dispositif selon l'une des revendications précédentes, dans lequel l'au moins un élément diélectrique (2) comprend en outre au moins un pilier (24) dont la dimension longue s'étend suivant au moins une partie de l'épaisseur de la couche supérieure (12), et de préférence dans lequel l'au moins un pilier (24) est situé en regard de l'élément de raccordement sous la couche diélectrique (40).

7. Dispositif selon l'une des revendications précédentes, dans lequel l'au moins un élément diélectrique (2) comprend un réseau de tranchées défini en creux dans l'épaisseur de la couche supérieure (12) autour d'une pluralité de piliers (25) s'étendant au moins dans l'épaisseur de la couche supérieure (2), et de préférence dans lequel au moins un pilier (25) est situé en regard de l'élément de raccordement sous la couche diélectrique (12), et de préférence dans lequel au moins une tranchée (21) entoure au moins un desdits piliers (24 ; 25).

8. Dispositif selon l'une des revendications précédentes, dans lequel l'au moins un élément diélectrique (2) comprend une pluralité de tranchées (21).

9. Dispositif selon l'une des revendications précédentes, dans lequel l'au moins un élément diélectrique (2) comprend une première partie située dans la couche supérieure (12) et une deuxième partie (23) située au-dessus de la couche supérieure.

10. Dispositif selon l'une des revendications précédentes, dans lequel l'élément de raccordement électrique (81, 82, 84) comprend un plot de connexion.

11. Dispositif selon l'une des revendications précédentes, dans lequel la couche diélectrique (40) est plus large que l'élément de raccordement électrique (81, 82, 84) et en ce que l'au moins un élément diélectrique (2) est situé en regard d'une partie de la couche diélectrique (40) non recouverte par l'élément de raccordement.

12. Dispositif selon l'une des revendications précédentes, dans lequel l'élément diélectrique (2) parcourt toute l'épaisseur de la couche supérieure (12) et rejoint la portion diélectrique (11).

13. Procédé de fabrication d'un dispositif microélectronique comprenant un substrat comportant en empilement une portion de base (10), une portion diélectrique (11) et une couche supérieure (12) à base de matériau semi-conducteur, le procédé comprenant :
- la formation d'au moins un élément diélectrique (2) situé au moins en partie dans la couche supérieure (12), l'au moins un élément diélectrique (2) ayant une partie exposée à la surface de la couche supérieure (12), ledit au moins un élément diélectrique (2) comprenant au moins une tranchée (21) remplie d'un matériau diélectrique solide et délimitant une zone fermée de ladite couche supérieure, en périphérie ou au droit d'au moins une partie d'un élément de raccordement électrique (81, 82, 84) ;
- la formation d'une couche diélectrique (40) au contact de la surface de la couche supérieure (12) et qui recouvre totalement la partie exposée de l'au moins un élément diélectrique (2) ;
- la formation dudit élément de raccordement électrique en un matériau électriquement conducteur au-dessus de la couche supérieure (12) et isolé électriquement de la couche supérieure (12) au moins par la couche diélectrique (40).

14. Procédé selon la revendication précédente, comprenant la formation d'au moins une zone en un matériau sacrificiel dans la couche supérieure (12), puis la gravure du matériau sacrificiel alors que le au moins un élément diélectrique (2) est recouvert par la couche diélectrique (40).

15. Procédé selon la revendication précédente, dans lequel la formation d'au moins une zone en un matériau sacrificiel est opérée avant la formation de la couche diélectrique (40), simultanément à la formation de l'au moins un élément diélectrique (2), et de préférence dans lequel la formation de la couche diélectrique (40) comprend un dépôt pleine plaque puis une gravure configurée pour préserver le matériau de la couche diélectrique (40) au-dessus de l'au moins un élément diélectrique (2) sans préserver le matériau de la couche diélectrique (40) au-dessus de la zone en un matériau sacrificielle.

## Patentansprüche

1. Mikroelektronische Vorrichtung, umfassend:
- ein Substrat (1), das in Stapelform einen Basisabschnitt (10), einen dielektrischen Abschnitt (11) und eine obere Schicht (12) auf Basis eines Halbleitermaterials beinhaltet,
- mindestens ein elektrisches Anschlusselement (81, 82, 84) aus einem elektrisch leitfähigen Material, das sich oberhalb der oberen Schicht (12) befindet und elektrisch von der oberen Schicht mindestens durch eine dielektrische Schicht (40) isoliert ist, wobei die dielektrische Schicht (40) in Kontakt mit der Oberfläche der oberen Schicht (12) ist,
- mindestens ein dielektrisches Element (2), das mindestens einen Graben (21) umfasst, der mit einem festen dielektrischen Material gefüllt ist, wobei der Graben (21) an der Peripherie oder auf Höhe mindestens eines Teils des elektrischen Anschlusselements (81, 82, 84), der sich mindestens teilweise in der oberen Schicht (12) befindet und eine geschlossene Zone der oberen Schicht begrenzt, eine geschlossene Kontur bildet, wobei das mindestens eine dielektrische Element (2) einen Teil aufweist, der der Oberfläche der oberen Schicht ausgesetzt ist,
wobei in der Vorrichtung die dielektrische Schicht (40) den Teil, der dem mindestens einen dielektrischen Element (2) ausgesetzt ist, vollständig abdeckt.

2. Vorrichtung nach dem vorstehenden Anspruch, wobei das mindestens eine dielektrische Element (2) und die dielektrische Schicht (40) aus unterschiedlichen Materialien sind.

3. Vorrichtung nach dem vorstehenden Anspruch, wobei das mindestens eine dielektrische Element (2) aus Siliciumdioxid ist, und wobei die dielektrische Schicht (40) einer Gravur mit Flusssäure widersteht, und wobei die dielektrische Schicht (40) von piezoelektrischer Art ist.

4. Vorrichtung nach einem der vorstehenden Ansprüche, wobei das mindestens eine elektrische Anschlusselement (81, 82, 84) in elektrischer Kontinuität mit einer ersten Elektrode (100) eines kapazitiven Stapels ist.

5. Vorrichtung nach dem vorstehenden Anspruch, wobei der kapazitive Stapel eine zweite Elektrode (3) umfasst, die sich unterhalb eines Teils der dielektrischen Schicht (40) befindet, wobei sich mindestens ein Teil der ersten Elektrode (100) gegenüber der zweiten Elektrode befindet und von dieser durch den Teil der dielektrischen Schicht (40) isoliert ist, und wobei sich vorzugsweise eine dielektrische Unterschicht (31) zwischen der oberen Schicht (12) und der zweiten Elektrode (3) befindet und die Vorrichtung vorzugsweise ein zusätzliches elektrisches Anschlusselement aus einem elektrisch leitfähigen Material umfasst, das sich oberhalb der oberen Schicht (12) befindet und elektrisch mindestens durch eine Zone der dielektrischen Schicht (40) von der oberen Schicht (12) isoliert ist, wobei das zusätzliche elektrische Anschlusselement über eine Durchkontaktierung (6), die die dielektrische Schicht (40) durchquert, in elektrischer Kontinuität mit der zweiten Elektrode (3) ist.

6. Vorrichtung nach einem der vorstehenden Ansprüche, wobei das mindestens eine dielektrische Element (2) weiter mindestens eine Säule (24) umfasst, deren lange Abmessung sich entlang mindestens eines Teils der Dicke der oberen Schicht (12) erstreckt, und wobei sich die mindestens eine Säule (24) vorzugsweise gegenüber dem Anschlusselement unter der dielektrischen Schicht (40) befindet.

7. Vorrichtung nach einem der vorstehenden Ansprüche, wobei das mindestens eine dielektrische Element (2) ein Netz an Gräben umfasst, das als Vertiefung in der Dicke der oberen Schicht (12) um eine Vielzahl von Säulen (25) herum definiert ist, die sich mindestens in der Dicke der oberen Schicht (2) erstreckt, und wobei sich mindestens eine Säule (25) vorzugsweise gegenüber dem Anschlusselement unter der dielektrischen Schicht (12) befindet, und wobei mindestens ein Graben (21) vorzugsweise mindestens eine der Säulen (24; 25) umgibt.

8. Vorrichtung nach einem der vorstehenden Ansprüche, wobei das mindestens eine dielektrische Element (2) eine Vielzahl von Gräben (21) umfasst.

9. Vorrichtung nach einem der vorstehenden Ansprüche, wobei das mindestens eine dielektrische Element (2) einen ersten Teil umfasst, der sich in der oberen Schicht (12) befindet, und einen zweiten Teil (23), der sich oberhalb der oberen Schicht befindet.

10. Vorrichtung nach einem der vorstehenden Ansprüche, wobei das elektrische Anschlusselement (81, 82, 84) einen Verbindungsstift umfasst.

11. Vorrichtung nach einem der vorstehenden Ansprüche, wobei die dielektrische Schicht (40) größer ist als das elektrische Anschlusselement (81, 82, 84), und dadurch, dass sich das mindestens eine dielektrische Element (2) gegenüber einem Teil der dielektrischen Schicht (40) befindet, der nicht von dem Anschlusselement abgedeckt ist.

12. Vorrichtung nach einem der vorstehenden Ansprüche, wobei das dielektrische Element (2) die gesamte Dicke der oberen Schicht (12) durchläuft und sich dem dielektrischen Abschnitt (11) annähert.

13. Verfahren zur Herstellung einer mikroelektronischen Vorrichtung, ein Substrat umfassend, das in Stapelform einen Basisabschnitt (10), einen dielektrischen Abschnitt (11) und eine obere Schicht (12) auf Basis eines Halbleitermaterials beinhaltet, wobei das Verfahren umfasst:
- das Bilden mindestens eines dielektrischen Elements (2), das sich mindestens teilweise in der oberen Schicht (12) befindet, wobei das mindestens eine dielektrische Element (2) einen Teil aufweist, der der Oberfläche der oberen Schicht (12) ausgesetzt ist, wobei das mindestens eine dielektrische Element (2) mindestens einen Graben (21) umfasst, der mit einem festen dielektrischen Material gefüllt ist, und eine geschlossene Zone der oberen Schicht, an der Peripherie oder auf Höhe mindestens eines Teils eines elektrischen Anschlusselements (81, 82, 84) begrenzt;
- das Bilden einer dielektrischen Schicht (40) in Kontakt mit der Oberfläche der oberen Schicht (12) und die den Teil, der dem mindestens einen dielektrischen Element (2) ausgesetzt ist, vollständig abdeckt;
- das Bilden des elektrischen Anschlusselements aus einem elektrisch leitfähigen Material oberhalb der oberen Schicht (12), und elektrisch mindestens durch die dielektrische Schicht (40) von der oberen Schicht (12) isoliert.

14. Verfahren nach dem vorstehenden Anspruch, umfassend das Bilden mindestens einer Zone aus einem Opfermaterial in der oberen Schicht (12), danach das Gravieren des Opfermaterials, während das mindestens eine dielektrische Element (2) durch die dielektrische Schicht (40) abgedeckt ist.

15. Verfahren nach dem vorstehenden Anspruch, wobei das Bilden mindestens einer Zone aus einem Opfermaterial vor dem Bilden der dielektrischen Schicht (40) gleichzeitig mit dem Bilden des mindestens einen dielektrischen Elements (2) vorgenommen wird, und wobei das Bilden der dielektrischen Schicht (40) vorzugsweise das Abscheiden einer festen Platte und danach eine Gravur umfasst, die konfiguriert ist, um das Material der dielektrischen Schicht (40) oberhalb des mindestens einen dielektrischen Elements (2) zu bewahren, ohne das Material der dielektrischen Schicht (40) oberhalb der Zone aus einem Opfermaterial zu bewahren.

## Claims

1. Microelectronic device comprising:
- a substrate (1) having a base portion (10), a dielectric portion (11) and a top layer (12) with a semi-conductive material base, in a stack,
- at least one electrical connection element (81, 82, 84) made of an electrically conductive material located above the top layer (12) and electrically insulated from the top layer at least by a dielectric layer (40), the dielectric layer (40) being in contact with the surface of the top layer (12),
- at least one dielectric element (2) comprising at least one trench (21) filled with a solid dielectric material, said trench (21) forming a closed contour peripheral to or upright to at least a part of the electrical connection element (81, 82, 84), located at least partially in the top layer (12) and delimiting a closed area of said top layer, the at least one dielectric element (2) having an exposed part at the surface of the top layer,
wherein the dielectric layer (40) completely covers the exposed part of the at least one dielectric element (2).

2. Device according to the preceding claim, wherein the at least one dielectric element (2) and the dielectric layer (40) are made of different materials.

3. Device according to the preceding claim, wherein the at least one dielectric element (2) is made of silicon dioxide and wherein the dielectric layer (40) is resistant to hydrofluoric acid etching, and preferably wherein the dielectric layer (40) is of the piezoelectric kind.

4. Device according to one of the preceding claims, wherein the at least one electrical connection element (81, 82, 84) is in electrical continuity with a first electrode (100) of a capacitive stack.

5. Device according to the preceding claim, wherein the capacitive stack comprises a second electrode (3) located below a part of the dielectric layer (40), at least one part of the first electrode (100) being located facing the second electrode and insulated therefrom by said part of the dielectric layer (40), and preferably wherein a dielectric sublayer (31) is located between the top layer (12) and the second electrode (3), and the device preferably comprising an additional electrical connection element made of an electrically conductive material located above the top layer (12) and electrically insulated from the top layer (12) at least by an area of the dielectric layer (40), the additional electrical connection element being in electrical continuity with the second electrode (3) by a via (6) passing through the dielectric layer (40).

6. Device according to one of the preceding claims, wherein the at least one dielectric element (2) further comprises at least one pillar (24), the long dimension whereof extends along at least part of the thickness of the top layer (12), and preferably wherein the at least one pillar (24) is located facing the connecting element under the dielectric layer (40).

7. Device according to one of the preceding claims, wherein the at least one dielectric element (2) comprises an array of trenches recessed in the thickness of the top layer (12) around a plurality of pillars (25) extending at least into the thickness of the top layer (2), and preferably wherein at least one pillar (25) is located facing the connection element under the dielectric layer (12), and preferably wherein at least one trench (21) surrounds at least one of said pillars (24; 25).

8. Device according to one of the preceding claims, wherein the at least one dielectric element (2) comprises a plurality of trenches (21).

9. Device according to one of the preceding claims, wherein the at least one dielectric element (2) comprises a first part located in the top layer (12) and a second part (23) located above the top layer.

10. Device according to one of the preceding claims, wherein the electrical connection element (81, 82, 84) comprises a bonding pad.

11. Device according to one of the preceding claims, wherein the dielectric layer (40) is wider than the electrical connection element (81, 82, 84) and wherein the at least one dielectric element (2) is located facing a part of the dielectric layer (40) not covered by the connection element.

12. Device according to one of the preceding claims, wherein the dielectric element (2) passes through the entire thickness of the top layer (12) and joins the dielectric portion (11).

13. Method for manufacturing a microelectronic device comprising a substrate having a base portion (10), a dielectric portion (11) and a top layer (12) with a semi-conductive material base, in a stack, the method comprising:
- forming at least one dielectric element (2) located at least partially in the top layer (12), the at least one dielectric element (2) having an exposed part at the surface of the top layer (12), said at least one dielectric element (2) comprising at least one trench (21) filled with a solid dielectric material and delimiting a closed area of said top layer, peripheral to or at right angles to at least one part of an electrical connection element (81, 82, 84);
- forming a dielectric layer (40) in contact with the surface of the top layer (12) and completely covering the exposed part of the at least one dielectric element (2);
- forming said electrical connection element made of an electrically conductive material above the top layer (12) and electrically insulated from the top layer (12) at least by the dielectric layer (40).

14. Method according to the preceding claim, comprising forming at least one area made of a sacrificial material in the top layer (12), then etching the sacrificial material while the at least one dielectric element (2) is covered by the dielectric layer (40).

15. Method according to the preceding claim, wherein the formation of at least one area made of a sacrificial material is carried out prior to the formation of the dielectric layer (40), simultaneously with the formation of the at least one dielectric element (2), and preferably wherein the formation of the dielectric layer (40) comprises full wafer deposition then etching configured to preserve the material of the dielectric layer (40) above the at least one dielectric element (2) without preserving the material of the dielectric layer (40) above the area made of a sacrificial material.
